(19) **Europäisches Patentamt / European Patent Office / Office européen des brevets**

(11) **EP 2 182 083 B1**

(12) **EUROPEAN PATENT SPECIFICATION**

(45) Date of publication and mention
of the grant of the patent:
**11.09.2013 Bulletin 2013/37**

(51) Int Cl.:
$C22C\ 9/00$ (2006.01)     $C22F\ 1/08$ (2006.01)
$C23C\ 14/34$ (2006.01)     $C23C\ 14/16$ (2006.01)

(21) Application number: **08105733.3**

(22) Date of filing: **04.11.2008**

(54) **Copper-gallium alloy sputtering target and method for fabricating the same**

Sputter-Target aus Kupfer-Gallium-Legierung und Verfahren zu seiner Herstellung

Cible de pulvérisation d'alliage cuivre-gallium et son procédé de fabrication

(84) Designated Contracting States:
**AT BE BG CH CY CZ DE DK EE ES FI FR GB GR HR HU IE IS IT LI LT LU LV MC MT NL NO PL PT RO SE SI SK TR**

(43) Date of publication of application:
**05.05.2010 Bulletin 2010/18**

(73) Proprietor: **Solar Applied Materials Technology Corp.**
**Annan Dist , Tainan (TW)**

(72) Inventors:
 • **Huang, Wei-Chihn**
  **Tainan (TW)**
 • **Tu, Cheng-Hsin**
  **Tainan (TW)**

(74) Representative: **Dossmann, Gérard**
**Casalonga & Partners**
**Bayerstrasse 71-73**
**80335 München (DE)**

(56) References cited:
**EP-A- 0 838 863**     **WO-A-2004/011691**
**CN-A- 1 719 626**     **JP-A- 2000 073 163**
**US-A1- 2003 052 000**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The present invention relates to a method for fabricating a sputtering target, and more particularly to a method for fabricating a copper-gallium alloy sputtering target comprising a solid-solution phase principally.

Non- renewable fuels are being exhausted, with peak oil, coal and gas approaching and nuclear requiring significant clean up costs, development of renewable energy is increasingly important. Photovoltaic solar cells, convert solar radiation directly into electricity for later use and include wafer type solar cells and thin- film type solar cells. Wafer type solar cells are current market leaders but have an indirect band gap for absorbing light, so a thick substrate layer of silicon (Si) is required. Since quantities of silicon are also limited, and the thick substrate raises production costs and practical usage, thin- film type solar cells are preferred in many instances, and may be formed as a thin layer on other materials and may be implemented as windows or the like. Thin film type solar cells include compositions of copper (Cu) , gallium (Ga) , indium (In) and selenium (Se) and are named after their constituent parts, copper- indium- selenium (CIS solar cells) , copper- indium- gallium- selenium (CIGS solar cells) and the like.

CIGS forms an absorbing layer. Because CIGS is a direct band gap material which has high photovoltaic conversion efficiency, so it is adaptable for use as absorbing layer for solar cells.

A CIGS thin film can be produced by chemical vapor deposition (CVD) with reference to US 5,474,939, physical vapor deposition (PVD), co-evaporation with reference to US 5,141,564, liquid phase deposition (LPE) or the like. PVD may use sputtering to form the thin film in CIGS solar cell. Sputtering comprises forming a sputter target and a substrate, then sputtering the sputter target onto the substrate.

The CIGS thin film can also be produced by a selenization procedure as disclosed in JP10-135495, wherein an absorbent layer such as CIG is selenized to form the CIGS thin film. The sputter target can be produced by powder metallurgy or casting. When powder metallurgy is used, because gallium and indium both have low melting points, they are hard to be sintered. Furthermore, a procedure for retrieving target residues is complicated, which increases cost of production of the sputter target. When casting is used, melting points of copper, indium, gallium and selenium vary greatly, from 1083 °C for copper to 29.8 °C for gallium, so those materials do not precipitate to form a non-uniform thin film.

The CIGS thin film can also be produced by selenization as disclosed in Jap10-135495, wherein an absorbent layer such as CIG is selenized to form the CIGS thin film.

Vacuum induction melting (VIM) is used to produce a conventional Cu alloy target such as Cu-In-Ga target or Cu-Ga target, wherein a eutectic micro-structure of copper-alloy target includes a solid solution phase and a compound phase, wherein the compound phase is usually about 30 ~ 40 % on a metallurgical microstructure of the copper-alloy target, However, such micro-structure of the copper-alloy target has the following disadvantages:

(1) the copper target has non-uniform distribution of materials, resulting in macro segregation or micro segregation;
(2) two phases of the copper-alloy target result in a non-uniform thin film with poor properties (such as light-electricity conversion efficiency and the like);
(3) two phases of the Cu alloy target induce micro arcing during sputtering, which results in a thin film with poor quality.

Therefore, a cost of production and efficiency of the CIGS solar cell is dependent on the sputter target.

To overcome the shortcomings, the present invention provides method for fabricating a copper-gallium alloy sputtering target to mitigate or obviate the aforementioned.

The primary objective of the present invention is to provide a method for fabricating a copper-gallium alloy sputtering target comprising a solid-solution phase principally.

To achieve the objective, the method for fabricating a copper-gallium alloy sputtering target in accordance with the present invention comprises forming a raw target; treating the raw target with at least one thermal treatment between 500 °C ~ 850 °C, which may be at least one thermal mechanical treatment, at least one thermal annealing treatment for 0.5 ~ 5 hours or a combination thereof to form a treated target; and cooling the treated target to room temperature to obtain the copper-gallium alloy sputtering target that has 71 atomic% to 78 atomic% of Cu and 22 atomic% to 29 atomic% of Ga and having a compound phase not more than 25% on its metallurgical microstructure.

Therefore, the copper- gallium alloy sputtering target does not induce micro arcing during sputtering, allowing a consistent sputtering rate to form a uniform copper- gallium thin film. Accordingly, the copper- gallium thin film possesses improved quality and properties.

Other objectives, advantages and novel features of the invention will become more apparent from the following detailed description when taken in conjunction with the accompanying drawings.

IN THE DRAWINGS

Fig. 1 is a phase diagram of a copper-gallium (Cu-Ga) alloy of a conventional Cu-Ga alloy target;

Fig. 2 is a metallurgical micrograph of a conventional Cu-Ga alloy target in accordance with the prior art;

Fig. 3 is a metallurgical micrograph of a Cu-Ga alloy target in example 1 in accordance with the present invention; and

Fig. 4 is a metallurgical micrograph of a Cu-Ga alloy target in example 2 in accordance with the present invention.

As used herein, "compound" is a substance consisting of two or more different elements chemically bonded together in a fixed proportion by mass. Compounds have different physical and chemical properties from their constituent elements.

As used herein, "solid solution" is a solid-state solution of one or more solutes in a solvent. Such a mixture is considered a solution rather than a compound when the crystal structure of the solvent remains unchanged by addition of the solutes, and when the mixture remains in a single homogeneous phase.

As used herein, "reduction ratio" is the ratio of thickness variation to feed thickness of a bulk material for a mechanical operation.

A method for fabricating a copper-gallium alloy sputtering target in accordance with the present invention comprises forming a raw target; treating the raw target with at least one thermal treatment between 500 °C ~ 850 °C thermal annealing treatment to form a treated target; and cooling the treated target to room temperature to obtain the copper-gallium alloy sputtering target that has 71 atomic% to 78 atomic% of Cu and 22 atomic% to 29 atomic% of Ga and having a compound phase not more than 25% on its metallurgical microstructure.

Forming the raw target may comprise forming the raw target using powder metallurgy or casting may be using vacuum melting, continuous casting, centrifugal casting, hot-press sintering, hot isostatic pressing (HIP), hot plastic forming or the like.

The at least one thermal treatment may be at least one mechanical treatment between 500 °C ~ 850 °C, at least one thermal annealing treatment between 500 °C ~ 850 °C for 0.5 ~ 5 hours or a combination thereof to form a treated target.

In one aspect, the at least one thermal treatment consists of treating the raw target with at least one thermal mechanical treatment.

In another aspect, the at least one thermal treatment consists of treating the raw target with at least one thermal annealing treatment.

In another aspect, the at least one thermal treatment consists of treating the raw target with at least one thermal mechanical treatment, then treating the raw target with at least one thermal annealing treatment.

In another aspect, the at least one thermal treatment consists of treating the raw target with at least one thermal annealing treatment, then treating the raw target with at least one thermal mechanical treatment.

In another aspect, the at least one thermal treatment consists of treating the raw target with at least one mechanical treatment, then treating the raw target with at least one thermal annealing treatment then repeatedly treating the raw target with multiple thermal mechanical treatments.

Combinations of the above aspects may be altered to attain a preferred balance between cost of treatment and desired sputtering target.

Preferably, the thermal mechanical treatment comprises forging, rolling or hot pressing. Preferably, a reduction ratio during thermal mechanical treatment is 0- 90 %.

More preferably, a reduction ratio during thermal mechanical treatment is 0 ~ 50%.

Most preferably the thermal treatment comprises at least one rolling at 800°C at a reduction rate of 25% and at least one thermal annealing treatment at 700°C for 1 hour to attain a high ratio of solid-solution phase to compound phase.

Cooling the treated target comprises using air (air- cooling) , water (water- cooling) or oil (oil- cooling) .

The copper-gallium alloy sputtering target in accordance with the present invention comprises a copper-gallium alloy that has 71 atomic% to 78 atomic% of Cu and 22 atomic% to 29 atomic% of Ga and having a compound phase not more than 25% on its metallurgical microstructure.

Preferably, the average grain size in the alloy of the target is less than 1 mm.

Because the compound phase of the copper-gallium alloy sputtering target is not more than 25% on its metallographic microstructure, the microstructure substantially presents a single phase. Therefore, the copper-gallium alloy sputtering target does not induce micro arcing during sputtering so yields a consistent sputtering rate and forms a uniform copper-gallium thin film. Accordingly, the copper-gallium thin film possesses improved quality and properties.

In the following examples, the sputtering target was analyzed by using etching solution including $HNO_3$, $H_2O_2$ and water in a ratio of 3:1:1, to calculate a ratio of a compound phase and a solid-solution phase, a micrograph being taken using an Olympus BH microscope as made by Olympus, wherein the solid-solution phase is shown by light gray and the compound phase is shown by dark gray. A ratio of the solid-solution phase to the compound phase is calculated by image measurement software, Image-Pro Plus Version 6.3 as provided by MediaCybernetics, according to equation I and was calculated by image measurement software, Image-Pro Plus Version 6.3.

$$\frac{\text{compound phase [B]}}{\text{solid-solution phase [A]+ compound phase [B]}} \qquad \text{Equation 1}$$

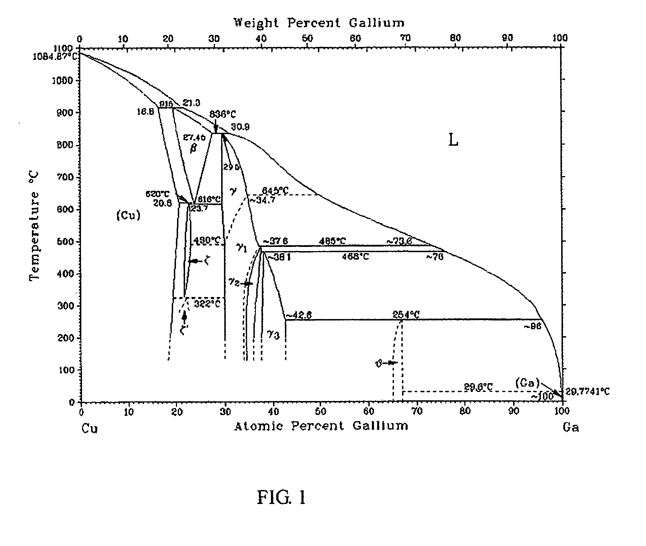

With reference to Fig. 1, showing a phase diagram of Cu-Ga alloy of a conventional Cu-Ga alloy target being a eutectic system including a solid solution phase (β phase) and a compound phase (γ phase). A theoretical ratio of the compound phase and the solid-solution phase is calculated by equation 1, yielding 30~40 %, wherein A is then β phase and B is the γ phase, so the compound phase is usually about 30 - 40 % on the metallographic microstructure of the Cu alloy target.

Another conventional Cu-Ga alloy sputter target comprises 75 wt% of copper and 25 wt% of gallium, which is fabricated by casting.

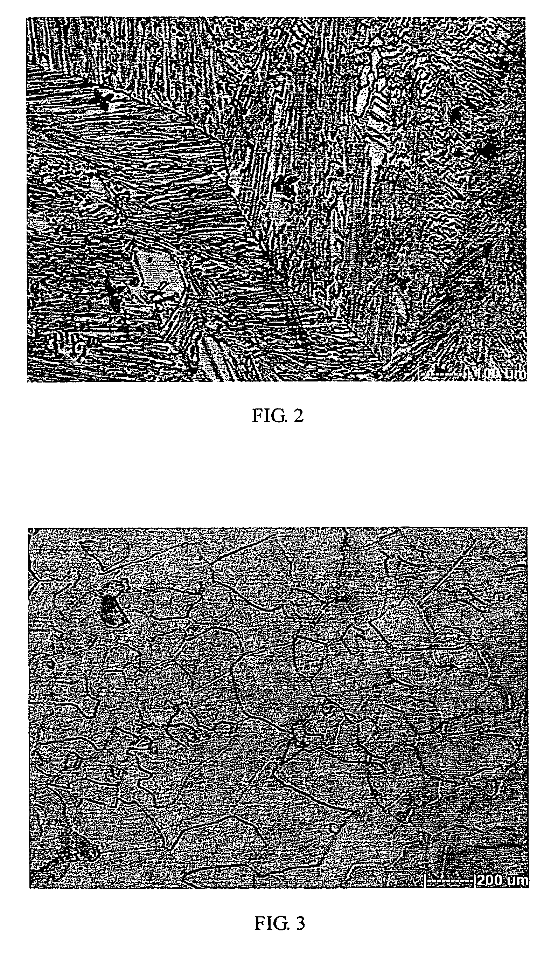

With reference to Fig. 2, wherein the solid solution phase is shown by light gray and the compound phase is shown by dark gray. The empirical ratio as calculated by by equation 1 is 30.4 %; therefore, the empirical ratio is consistent with the theoretical ratio.

The method of the present invention relates to solid-state phase transformation and atom diffusion of Cu-Ga alloy, which affects the ratio of the compound phase and the solid-solution phase on it microstructure of the copper-gallium alloy sputtering target. Therefore, regardless of whether the raw target is formed by powder metallurgy or casting, after the method of the present invention, the copper-gallium alloy sputtering target substantially comprising the solid-solution phase is obtained as shown in Fig. 3.

**Example**

The following examples present methods of heat treatment of the present invention for fabricating Cu-Ga alloy sputtering targets and compare those Cu-Ga alloy sputtering targets. Each target before treatment was shown to have an empirical ratio of around 35%. Such examples are illustrative only, and no limitation on present invention is meant thereby.

Example 1.

A raw target was formed by vacuum melting. The raw target was treated by rolling at 800°C at a reduction ratio of 25 %, then was treated by thermal annealing treatment at 700°C for 1 hour and cooled to room temperature to form a Cu-Ga alloy sputtering target.

Example 2.

A raw target was formed by air melting. The raw target was treated by thermal annealing treatment at 800 °C for 1 hour and then was treated by rolling at 800 °C at a reduction ratio of 25 % then cooled to room temperature to form a Cu-Ga alloy sputtering target.

Example 3.

A raw target was formed by vacuum melting. The raw target was treated by hot-press sintering at 600°C then was treated by thermal annealing treatment at 800 °C for 1 hour, before being cooled to room temperature to form a Cu-Ga alloy sputtering target.

Example 4.

A raw target was formed by vacuum melting. The raw target was treated by rolling at 700°C at a reduction ratio of 40 % then was cooled to room temperature to form a Cu-Ga alloy sputtering target.

Example 5.

A raw target was formed by vacuum melting. The raw target was treated by thermal annealing treatment at 700°C for 3 hours and cooled to room temperature to form a Cu-Ga alloy sputtering target.

Example 6. (Comparative example)

A raw target was formed by vacuum melting. The raw target was treated by rolling at 400 °C at a reduction ratio of 25 % then was cooled to room temperature to form a Cu-Ga alloy sputtering target.

Table 1. Conditions and results of examples

| Ex | TMT | TA | B/(A+B) (raw target) | B/(A+B) (target) |
|---|---|---|---|---|
| 1 | Rolling r.r. : 25 % Temp : 800°C | Temp:700°C Time: 1 hr | ~35% | <5 % |
| 2 | Rolling r.r.:25 % Temp:80°C | Temp:800°C Time: 1 hr | ~35 % | <20% |
| 3 | hot-press sintering Temp:600 °C | Temp:800°C Time:1 hr | ~35% | <20 % |
| 4 | Rolling r.r :40 % Temp:700 °C | - | ~35% | <25% |
| 5 | - | Temp:700°C Time:3 hr | ~35% | <20 % |
| 6 | Rolling r.r :25 % Temp:400 °C | - | ~35% | ~35% |

With reference to Table 1, TA is thermal annealing treatment and TMT is thermal mechanical treatment. According to Table 1 all raw targets had 35% of the compound phase before being treated. After the methods of the present invention as shown in examples 1 to 5, the compound phase of each Cu-Ga alloy sputtering target was apparently reduced. However, the Cu-Ga alloy sputtering target in example 6 was only treated at 400 °C, which does not belong to the scope of the present invention, the empirical ratio between the solid-solution and compound phases was not reduced. Therefore, a eutectic system including two phases still existed in the Cu-Ga alloy sputtering target in example 6.

Fig. 3 shows the metallurgical micrograph of example 1, which was taken by a microscope, Olympas BH, and was calculated by image measurement software, Image-Pro Plus Version 6.3. Example 1 shows preferable conditions of the method of the present invention. The compound phase is only 5 % on the metallographic microstructure of the Cu-Ga alloy sputtering target, so the Cu-Ga alloy sputtering target substantially comprises a single phase.

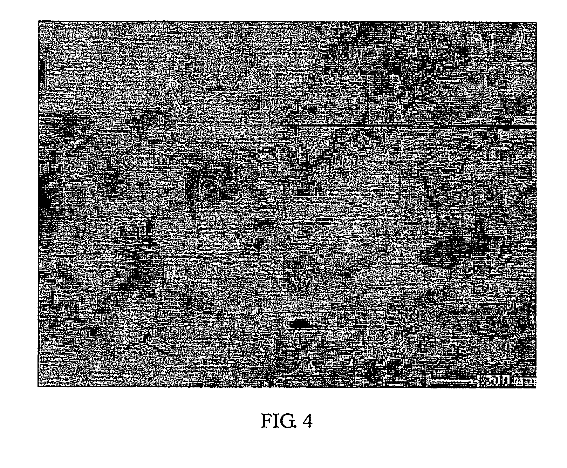

Fig. 4 shows the metallurgical micrograph of example 2, which was taken by a microscope, Olympas BH, and was calculated by image measurement software, Image-Pro Plus Version 6.3. The compound phase is 25 % on the metallographic microstructure of the Cu-Ga alloy sputtering target. Although the result of example 2 is not as good as example 3, the result shows improvement over example 6.

## Claims

1. A copper-gallium alloy sputtering target comprising an alloy, that consists of 71 atomic% to 78 atomic% of Cu and 22 atomic% to 29 atomic% of Ga, and having a compound phase not more than 25% on its metallographic micro-structure.

2. The copper-gallium alloy sputtering target as claimed in claim 1, wherein the average grain size in the alloy of the target is less than 1 mm.

3. A method for fabricating a copper-gallium alloy sputtering target comprising:

   forming a raw target;
   treating the raw target with at least one thermal mechanical treatment between 500 °C ~ 850 °C, or at least one thermal annealing treatment between 500 °C ~ 850 °C for 0.5 ~ 5 hours or a combination thereof to form a treated target; and
   cooling the treated target to a room temperature to obtain the copper-gallium alloy sputtering target that consists of 71 atomic% to 78 atomic% of Cu and 22 atomic% to 29 atomic% of Ga, and having a compound phase not more than 25% on its metallographic microstructure.

4. The method as claimed in claim 3, wherein the thermal mechanical treatment comprises forging, rolling or hot pressing.

5. The method as claimed in claim 3, wherein a reduction ratio during thermal mechanical treatment is 0 ~ 90 %.

**6.** The method as claimed in claim 3, wherein a reduction ratio during thermal mechanical treatment is 0 ~ 50 %.

**7.** The method as claimed in claim 3, wherein cooling the treated target comprises using air, water or oil.

**8.** The method as claimed in claim 3, wherein forming the raw target comprises using powder metallurgy or casting.

**9.** The method as claimed in claim 3, wherein forming the raw target comprises using vacuum melting, continuous casting, centrifugal casting, hot-press sintering, hot isostatic pressing, hot plastic forming or the like.

## Patentansprüche

**1.** Sputtertarget aus einer Kupfer-Gallium Legierung, das eine Legierung umfasst, die aus 71 Atom% bis 78 Atom% Cu und 22 Atom% bis 29 Atom% Ga besteht und eine Verbindungsphase aufweist, die nicht mehr als 25 % der metallographischen Mikrostruktur einnimmt.

**2.** Sputtertarget aus einer Kupfer-Gallium Legierung wie in Anspruch 1 beansprucht, wobei die durchschnittliche Korngröße in der Legierung des Targets weniger als 1 mm beträgt.

**3.** Verfahren zum Anfertigen eines Sputtertargets aus einer Kupfer-Gallium Legierung umfassend:

Formen eines rohen Targets;
Behandeln des rohen Targets mit wenigstens einer thermomechanischen Behandlung zwischen 500 °C ~ 850 °C oder wenigstens einer thermalen Glühbehandlung zwischen 500 °C ~ 850 °C über 0,5 - 5 Stunden oder einer Kombination davon zum Formen eines behandelten Targets sowie
Abkühlen des behandelten Targets auf Raumtemperatur, um das Sputtertarget aus einer Kupfer-Gallium Legierung zu erhalten, das aus 71 Atom% bis 78 Atom% Cu und 22 Atom% bis 29 Atom% Ga besteht und eine Verbindungsphase aufweist, die nicht mehr als 25 % der metallographischen Mikrostruktur einnimmt.

**4.** Verfahren wie in Anspruch 3 beansprucht, wobei die thermomechanische Behandlung Schmieden, Walzen oder Heißpressen umfasst.

**5.** Verfahren wie in Anspruch 3 beansprucht, wobei das Reduktionsverhältnis während der thermomechanischen Behandlung 0 - 90 % beträgt.

**6.** Verfahren wie in Anspruch 3 beansprucht, wobei das Reduktionsverhältnis während der thermomechanischen Behandlung 0 - 50 % beträgt.

**7.** Verfahren wie in Anspruch 3 beansprucht, wobei das Abkühlen des behandelten Targets die Verwendung von Luft, Wasser oder Öl umfasst.

**8.** Verfahren wie in Anspruch 3 beansprucht, wobei das Formen des rohen Targets die Verwendung von Pulvermetallurgie oder Gießen umfasst.

**9.** Verfahren wie in Anspruch 3 beansprucht, wobei das Formen des rohen Targets die Verwendung von Vakuumschmelzen, Stranggießen, Schleudergießen, Heißpressesintern, isostatisches Heißpressen, Kunststoff-Warmverformung oder Ähnliches umfasst.

## Revendications

**1.** Cible pour pulvérisation cathodique en alliage de cuivre et de gallium, comprenant un alliage constitué de 71 à 78 % en atomes de cuivre et de 22 à 29 % en atomes de gallium et comportant une phase de composé qui ne représente pas plus de 25 % de sa microstructure métallographique.

**2.** Cible pour pulvérisation cathodique en alliage de cuivre et de gallium, conforme à la revendication 1, dans laquelle la dimension moyenne des grains, dans l'alliage de la cible, est inférieure à 1 mm.

**3.** Procédé de fabrication d'une cible pour pulvérisation cathodique en alliage de cuivre et de gallium, comportant les étapes suivantes :

- former une cible brute ;
- soumettre cette cible brute à au moins un traitement thermomécanique entre 500 et 850 °C, ou à au moins un traitement thermique de recuit entre 500 et 850 °C, durant 0,5 à 5 heures, ou à une combinaison de tels traitements, pour former une cible traitée ;
- et faire refroidir la cible traitée jusqu'à la température ambiante, pour obtenir une cible pour pulvérisation cathodique en alliage de cuivre et de gallium, constituée de 71 à 78 % en atomes de cuivre et de 22 à 29 % en atomes de gallium et comportant une phase de composé qui ne représente pas plus de 25 % de sa microstructure métallographique.

**4.** Procédé conforme à la revendication 3, dans lequel le traitement thermomécanique comprend une opération de forgeage, de laminage ou de compression à chaud.

**5.** Procédé conforme à la revendication 3, dans lequel le taux de réduction au cours du traitement thermomécanique vaut de 0 à 90 %.

**6.** Procédé conforme à la revendication 3, dans lequel le taux de réduction au cours du traitement thermomécanique vaut de 0 à 50 %.

**7.** Procédé conforme à la revendication 3, dans lequel, pour faire refroidir la cible traitée, on se sert d'air, d'eau ou d'huile.

**8.** Procédé conforme à la revendication 3, dans lequel, pour former la cible brute, on a recours à une opération de coulée ou de métallurgie des poudres.

**9.** Procédé conforme à la revendication 3, dans lequel, pour former la cible brute, on a recours à une opération de fusion sous vide, de coulée en continu, de coulée centrifuge, de frittage par compression à chaud, de pressage isostatique à chaud ou de formage plastique à chaud, ou à une opération similaire.

**Weight Percent Gallium**

FIG. 1

FIG. 2

FIG. 3

FIG. 4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5474939 A
- US 5141564 A

- JP 10135495 A